# EUROPEAN PATENT APPLICATION

(11) **EP 4 727 289 A2**
(43) Date of publication of application: **15.04.2026**
(21) Application number: 25189569.4
(22) Date of filing: 15.07.2025
(51) Int. Cl.: H10D 62/13, H10D 30/01, H10D 30/00, H10D 30/69, H10D 64/23

(54) **SEMICONDUCTOR DEVICES INCLUDING STRESSOR LAYERS AND METHODS OF FORMING THE SAME**

(30) Priority: 09.10.2024 US 202463705228 P; 20.03.2025 US 202519085342
(71) Applicant: Samsung Electronics Co., Ltd., Suwon-si, Gyeonggi-do 16677 (KR)
(72) Inventor: CHUNG, Wonkeun, 16677 Suwon-si, Gyeonggi-do (KR); KIM, Byounghoon, 16677 Suwon-si, Gyeonggi-do (KR); SEO, Kang-ill, San Jose, CA 95134 (US); JANG, Sangshin, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate (101), a source/drain region on the substrate (101), a channel structure (104) on the substrate (101) and electrically connected to the source/drain region, a gate structure (102) on the substrate (101) and at least partially surrounding the channel structure (104), and a stressor layer in contact with or extending into an upper surface of the source/drain region (108) and configured to apply compressive stress or tensile stress to the source/drain region.

## Description

### TECHNICAL FIELD

The present disclosure generally relates to the field of semiconductor devices and, more particularly, to semiconductor devices including stressor layers and methods of forming the same.

### BACKGROUND OF THE INVENTION

Integrated circuit (IC) devices, chips, and/or blocks may receive power and data signals from one or more external sources (e.g., a power source and a data source). Some IC devices may receive power and data signals via frontside conductive structures, which may provide power distribution networks (PDNs). For example, an IC device may include a frontside power distribution network (FSPDN) having one or more components that are formed during back-end-of-line (BEOL) processes, and conductive structures for data signals may be on the same side of an IC device as the FSPDN. IC devices may include various transistor structures, including, for example, two-dimensional (2D) planar structures, fin field-effect transistors (FinFETs), gate-all-around transistors, multi-bridge channel FETs (MBCFETs^{™}), and stacked transistors (e.g., three-dimensional (3D) stacked transistors).

More recently, backside PDNs (BSPDNs), in which a backside of an IC device is used as a PDN, have also been developed. In a BSPDN structure, a power rail may be formed on the backside of a semiconductor chip, IC device, or wafer (generally referred to herein as a semiconductor device), rather than on the frontside thereof. As such, the power rail may be on a side of the semiconductor structure (e.g., a side of a substrate of the IC device) that is opposite from the active components (e.g., transistors) of the IC device. Moreover, conductive structures for data signals may be on the frontside of the semiconductor device, and thus the BSPDN and the conductive structures for the data signals may be on opposite sides of the semiconductor device. BSPDN structures may improve power rail effectiveness, voltage drop (i.e., IR drop), high power delivery performance, and further scaling of standard cell height.

During fabrication of an IC device, source/drain regions and channel structures may undergo various processes, which can lead to variations in the strain within the source/drain regions and the channel structures. These variations may cause the carrier mobility in the channel structures to deteriorate, which can negatively impact the performance of the IC device. Accordingly, research is being conducted into ways to enhance the carrier mobility in IC devices.

### SUMMARY OF THE INVENTION

According to some embodiments, a semiconductor device includes a substrate, a source/drain region on the substrate, a channel structure on the substrate and electrically connected to the source/drain region, a gate structure on the substrate and at least partially surrounding the channel structure, and a stressor layer in contact with and/or extending into an upper surface of the source/drain region and configured to apply compressive stress or tensile stress to the source/drain region.

In some embodiments, the stressor layer extends into the upper surface of the source/drain region.

In some embodiments, a first distance between a lower surface of the stressor layer and an upper surface of the substrate is greater than a second distance between an upper surface of the channel structure and the upper surface of the substrate.

In some embodiments, the stressor layer includes a first portion in the source/drain region and a second portion on the upper surface of the source/drain region, and a first width of the first portion of the stressor layer in a direction parallel to an upper surface of the substrate is less than a second width of the second portion of the stressor layer in the direction.

In some embodiments, the stressor layer is free of overlap with the gate structure in a direction perpendicular to an upper surface of the substrate.

In some embodiments, the stressor layer overlaps the gate structure and the channel structure in a direction perpendicular to an upper surface of the substrate.

In some embodiments, the semiconductor device further includes a backside contact structure extending in the substrate and electrically connected to the source/drain region, and the stressor layer overlaps the backside contact structure in a direction perpendicular to an upper surface of the substrate.

In some embodiments, the source/drain region is a first source/drain region, the stressor layer is a first stressor layer, and the semiconductor device further includes a second source/drain region adjacent the first source/drain region, with the channel structure therebetween, and a second stressor layer in contact with and/or extending into an upper surface of the second source/drain region and configured to apply compressive stress or tensile stress to the second source/drain region.

In some embodiments, the second stressor layer is spaced apart from the first stressor layer, with the gate structure therebetween.

In some embodiments, the source/drain region is a first source/drain region, the semiconductor device further includes a second source/drain region adjacent the first source/drain region, with the channel structure therebetween, and the stressor layer is in contact with and/or extends into an upper surface of the second source/drain region and is configured to apply compressive stress or tensile stress to the second source/drain region.

In some embodiments, the stressor layer extends continuously from the upper surface of the first source/drain region to the upper surface of the second source/drain region.

In some embodiments, an outer side surface of the source/drain region is free of the stressor layer thereon.

In some embodiments, the stressor layer is configured to apply compressive stress to the source/drain region when the source/drain region comprises n-type impurities, and the stressor layer is configured to apply tensile stress to the source/drain region when the source/drain region comprises p-type impurities.

According to some embodiments, a semiconductor device includes a substrate, a first source/drain region and a second source/drain region spaced apart from each other on the substrate, a channel structure between the first source/drain region and the second source/drain region, the channel structure comprising a plurality of channel regions that are spaced apart from each other in a direction perpendicular to an upper surface of the substrate, a gate structure on the substrate and at least partially surrounding the channel structure, a backside contact structure extending in the substrate and electrically connected to the first source/drain region or the second source/drain region, and a stressor layer extending into an upper surface of the first source/drain region and configured to apply compressive stress or tensile stress to the first source/drain region.

In some embodiments, the stressor layer is a first stressor layer, and the semiconductor device further includes a second stressor layer extending into an upper surface of the second source/drain region and spaced apart from the first stressor layer, the second stressor layer configured to apply compressive stress or tensile stress to the second source/drain region.

In some embodiments, the stressor layer extends into an upper surface of the second source/drain region and is configured to apply compressive stress or tensile stress to the second source/drain region.

In some embodiments, the stressor layer overlaps the backside contact structure in the direction.

According to some embodiments, a method of forming a semiconductor device includes forming a stressor layer on or extending into an upper surface of a source/drain region and in contact with the source/drain region, where the stressor layer applies compressive stress or tensile stress to the source/drain region.

In some embodiments, forming the stressor layer includes forming a recess in the upper surface of the source/drain region, and forming the stressor layer in the recess.

In some embodiments, forming the stressor layer includes epitaxially growing the stressor layer on the source/drain region.

In some embodiments, forming the stressor layer includes depositing the stressor layer on the upper surface of the source/drain region using a deposition process.

In some embodiments, the method further includes forming a placeholder layer, removing the placeholder layer using an etching process, and forming a backside contact structure on a lower surface of the source/drain region in a space left after removing the placeholder layer.
Other devices, apparatuses, and/or methods according to example embodiments will become more apparent to one of ordinary skill in the art upon review of the following drawings and detailed description. It is intended that all such additional embodiments, in addition to any and all combinations of the above embodiments, be included within this description, be within the scope of the present disclosure, and be protected by the accompanying claims. It is noted that the drawings are not necessarily to scale and are not to be construed as limiting the scope of the invention.

### BRIEF DESCRIPTION OF THE DRAWINGS

FIG. 1A is a plan or layout view illustrating a semiconductor device according to some embodiments.
FIGS. 1B and 1C are cross-sectional views taken along line A-A' of FIG. 1A according to some embodiments.
FIGS. 2A and 2B are simplified schematic views illustrating source/drain regions and a channel structure of a semiconductor device according to some embodiments.
FIG. 3 is a flowchart illustrating a method of forming a semiconductor device according to some embodiments.
FIGS. 4A, 4B, 4C, 4D, 4E, 4F, 4G, 4H, and 4I are cross-sectional views illustrating a method of forming a semiconductor device according to some embodiments.
FIG. 5 is a cross-sectional view illustrating a method of forming a semiconductor device according to some embodiments.

### DETAILED DESCRIPTION

A B SPDN structure may include a power delivery network that includes one or more power rails on (in) a backside of a semiconductor device. Different ways to connect from the frontside to the backside may include, for example, a front via backside power rail (FV-BPR) and a direct backside contact (DBC). The DBC may be more effective in terms of process capability and dimension limitations than other ways of connecting the frontside to the backside.

Channel stress may be helpful for enhancing carrier mobility in a channel structure of a semiconductor device and may thus provide performance advantages for the semiconductor device. For example, enhanced carrier mobility in the channel structure may improve switching speeds and/or reduce power consumption of the semiconductor device. By introducing stress to the channel structure of the semiconductor device, the strain within the channel structure may be modified to optimize carrier mobility. For example, in a semiconductor device including one or more n-type transistors (e.g., an n-type MOSFET (NMOS)), tensile stress introduced in the channel structure may help enhance electron mobility. In a semiconductor device including one or more p-type transistors (e.g., a p-type MOSFET (PMOS)), compressive stress introduced in the channel structure may help enhance hole mobility.

During fabrication of a semiconductor device, the source/drain regions and the channel structures may undergo various processes, which can lead to variations in the strain within the source/drain regions and the channel structures. These variations may be exacerbated in semiconductor devices including BSPDN structures and/or channel structures implemented as nanosheets or nanowires, due to the additional processes associated therewith. As a result, the carrier mobility in the channel structures may deteriorate, thereby negatively impacting the performance of the semiconductor device. The orientation of the substrate (i.e., a wafer) and the channel structures may be controlled during fabrication to help enhance carrier mobility, but these techniques may not sufficiently offset the negative effects to the carrier mobility resulting from variations in the strain within the source/drain regions and the channel structures.

Pursuant to example embodiments herein, semiconductor (e.g., integrated circuit) devices are provided that include one or more stressor layers on upper surfaces (i.e., on the frontside) of source/drain regions to induce stress in the channel structures. As a result, the strain within the channel structures may be better controlled to improve carrier mobility. In some embodiments, the stressor layer(s) may extend into the upper surfaces of the source/drain regions, thereby allowing the stressor layer(s) to induce a greater degree of stress on the channel structures. Some examples of embodiments of the present disclosure are described in greater detail with reference to the attached figures.

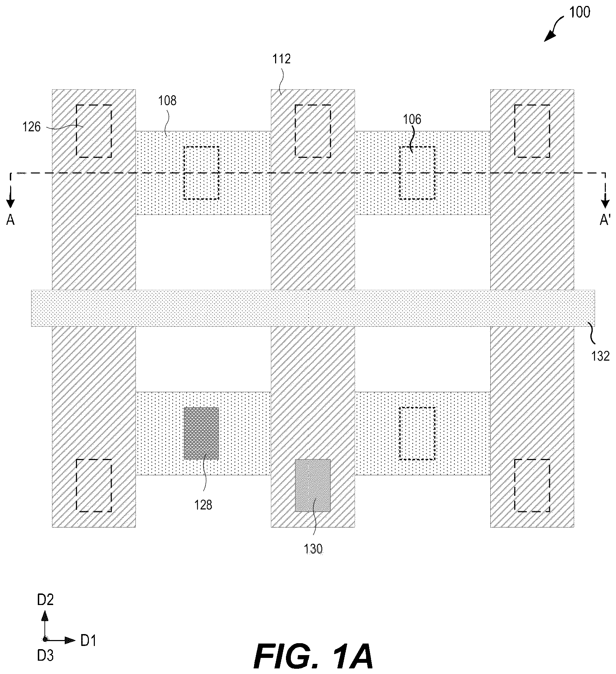

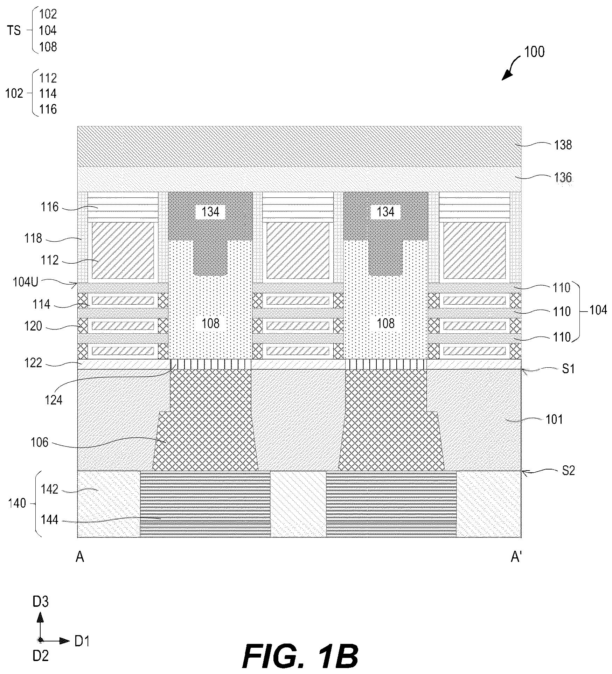

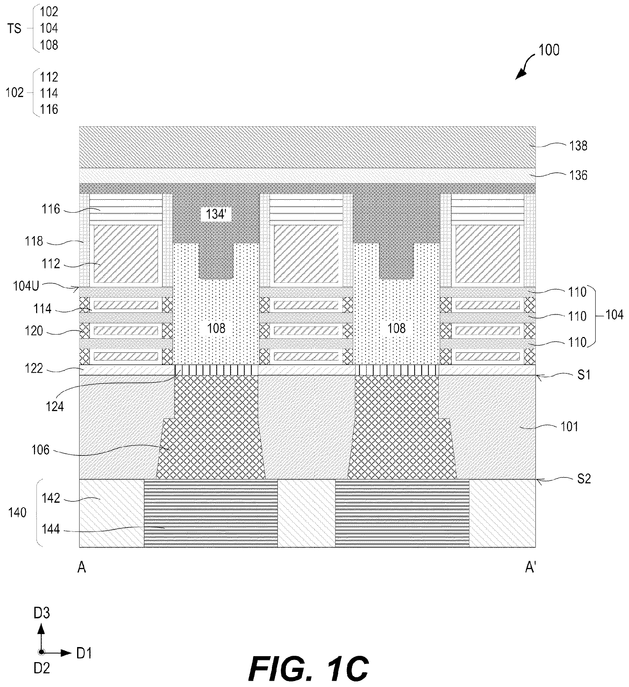

FIG. 1A is a plan or layout view illustrating a semiconductor device according to some embodiments. FIGS. 1B and 1C are cross-sectional views taken along line A-A' of FIG. 1A according to some embodiments. Some of the layers/structures shown in FIGS. 1B and 1C are omitted in FIG. 1A to help illustrate example embodiments.

Referring to FIGS. 1A and 1B, a semiconductor device 100 may include a substrate 101 (also referred to as a backside insulating layer) and transistor structures TS (also referred to as transistors) on an upper surface (or frontside) S1 of the substrate 101. The substrate 101 may extend in a first direction D1 (also referred to as a first horizontal direction or X direction) and a second direction D2 (also referred to as a second horizontal direction or Y direction). The first direction D1 and the second direction D2 may be parallel to a surface (e.g., the upper surface S1) of the substrate 101. In some embodiments, the first direction D1 may be perpendicular to the second direction D2.

In some embodiments, the substrate 101 may include or may be formed of insulating material(s), for example, silicon oxide, silicon oxynitride, silicon nitride, silicon carbonitride, silicon boron nitride and/or a low-k dielectric material. The low-k dielectric material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectrics. In some embodiments, the substrate 101 may include or may be semiconductor material(s), for example, Si, Ge, SiGe, GaP, GaAs, SiC, SiGeC and/or InP. For example, the substrate 101 may be insulating layer(s), a bulk substrate (e.g., a bulk silicon wafer) and/or a semiconductor-on-insulator (SOI) substrate. A thickness of the substrate 101 in a third direction D3 (also referred to as a vertical direction or Z direction) may be, for example, in a range of (about) 50 nanometers (nm) to 100 nm, but is not limited thereto. In some embodiments, the third direction D3 may be perpendicular to the first direction D1 and/or the second direction D2. The third direction D3 may be perpendicular to a surface (e.g., the upper surface S1) of the substrate 101.

A first interlayer 122 may be provided on the upper surface S1 of the substrate 101. In some embodiments, the first interlayer 122 may extend between the substrate 101 and the transistor structures TS and may contact the upper surface S1 of the substrate 101 and the transistor structures TS. For example, the first interlayer 122 may include insulating material(s) (e.g., silicon oxide, silicon oxynitride, silicon nitride, silicon carbonitride and/or a low-k material).

Each of the transistor structures TS may include a gate structure 102 and a channel structure 104 that extends between source/drain regions 108 (in the first direction D1). The gate structure 102 may be on the channel structure 104 and may overlap the channel structure 104 in the third direction D3. As used herein, "an element A overlaps an element B in a direction X" (or similar language) means that there is at least one straight line that extends in the direction X and intersects both the elements A and B. For example, the gate structure 102 may at least partially surround the channel structure 104. In some embodiments, the channel structure 104 may extend in the first direction D1, and the gate structure 102 may extend in the second direction D2.

In some embodiments, each of the channel structures 104 may include a plurality of channel regions 110 stacked in the third direction D3, and the channel regions 110 may be spaced apart from each other in the third direction D3. For example, in some embodiments, the transistor structures TS may be nanosheet transistors that include a stack of nanosheet layers in each channel structure 104. Although FIG. 1B illustrates that each channel structure 104 includes three channel regions 110, the present disclosure is not limited thereto. In some embodiments, each channel structure 104 may include less than three channel regions 110 or more than three channel regions 110.

The semiconductor device 100 may include multiple gate structures 102 that extend (i.e., longitudinally extend) in the second direction D2 and are spaced apart from each other in the first direction D1. Each gate structure 102 may include a gate electrode 112, a gate insulator 114, and a gate capping layer 116.

The gate electrode 112 may include a single layer or multiple layers. In some embodiments, the gate electrode 112 may include a metal layer or a material that includes, for example, tungsten (W), aluminum (Al), copper (Cu), molybdenum (Mo), cobalt (Co) and/or ruthenium (Ru), and may additionally include work function layer(s) (e.g., a TiN layer, a TaN layer, a TiAl layer, a TiC layer, a TiAlC layer, a TiAlN layer and/or a WN layer). For example, the work function layer(s) may separate the metal layer from the gate insulator 114. In some embodiments, gate electrodes 112 included in different gate structures 102 may include the same material(s).

The gate insulator 114 may extend between the gate electrode 112 and the channel structure 104. More particularly, the gate insulator 114 may contact and physically separate the gate electrode 112 and the channel structure 104 (including the channel regions 110). The gate insulator 114 may include a single layer or multiple layers (e.g., a silicon oxide layer and/or a high-k dielectric material layer). For example, the high-k dielectric material layer may include Al₂O₃, HfO₂, ZrO₂, HfZrO₄, TiO₂, Sc₂O₃, Y₂O₃, La₂O₃, Lu₂O₃, Nb₂O₅ and/or Ta₂O₅.

The gate capping layer 116 may be on an upper surface of the gate electrode 112. That is, the gate capping layer 116 may be on an uppermost portion of the gate electrode 112. The gate capping layer 116 may include, for example, silicon oxide, silicon oxynitride, silicon nitride, silicon carbonitride and/or a low-k material. In some embodiments, the gate capping layer 116 may include a different material from an upper gate insulating spacer 118 and/or a lower gate insulating spacer 120, but the present disclosure is not limited thereto.

In some embodiments, a gate cut layer 132 (see FIG. 1A) may separate portions of each gate electrode 112 in the second direction D2. For example, the gate cut layer 132 may extend in the first direction D1 to separate portions of each gate electrode 112 in the second direction D2. The gate cut layer 132 may include insulating material(s) (e.g., silicon oxide, silicon oxynitride, silicon nitride, silicon carbonitride, silicon boron nitride and/or a low-k material). In some embodiments, the gate cut layer 132 may be omitted.

Each of the transistor structures TS may also include a pair of source/drain regions 108 that are spaced apart from each other in the first direction D1. Each transistor structure TS may include a gate structure 102 and a channel structure 104 provided between the pair of source/drain regions 108. The source/drain regions 108 may contact opposing side surfaces of the channel structure 104 that are spaced apart from each other in the first direction D1.

The channel structure 104 may include semiconductor material(s) (e.g., Si, Ge, SiGe, GaP, GaAs, SiC, SiGeC and/or InP). That is, each of the channel regions 110 may include semiconductor material(s) (e.g., Si, Ge, SiGe, GaP, GaAs, SiC, SiGeC and/or InP). In some embodiments, the channel regions 110 may be nanosheets that may have a thickness, for example, in a range of (about) 1 nm to 100 nm in the third direction D3 or may be nanowires that may have a circular cross-section with a diameter, for example, in a range of (about) 1 nm to 100 nm. When the channel structure 104 includes a nanosheet or nanowire, the gate structure 102 may extend around (i.e., may at least partially surround) the channel structure 104 on multiple sides thereof.

Each of the source/drain regions 108 may include a semiconductor layer (e.g., a silicon (Si) layer and/or a silicon germanium (SiGe) layer) and may additionally include dopants in the semiconductor layer. For example, each of the source/drain regions 108 may include an epitaxial semiconductor layer having dopants (i.e., impurities) therein.

In some embodiments, the transistor structure TS may be a three-dimensional (3D) field-effect transistor (FET) such as a multi-bridge channel FET (MBCFET). In some embodiments, the transistor structure TS may have a structure different from that illustrated. For example, the transistor structure TS may be a gate-all-around FET (GAAFET) including a single channel structure or a fin-shaped FET (FinFET).

Stressor layers 134 may be provided on upper surfaces of the source/drain regions 108, respectively, and may be in contact with the source/drain regions 108. The stressor layers 134 may apply compressive stress or tensile stress to respective ones of the source/drain regions 108, and thus the stressor layers 134 may also be referred to as mechanical stressor layers. In some embodiments, the stressor layers 134 may include a different material from the source/drain regions 108. For example, the stressor layers 134 may include a dielectric material (e.g., SiOC, SiON, SiCN, SiN, Tonen SilaZene (TOSZ), tetraethyl orthosilicate (TEOS), atomic layer deposition (ALD) oxide, flowable chemical vapor deposition (FCVD) oxide, high density plasma (HDP) oxide, and/or plasma enhanced oxidation (PEOX) oxide), a metal material (e.g., tungsten (W) and/or molybdenum (Mo)), or a combination thereof. In some embodiments, the stressor layers 134 may include an epitaxial semiconductor layer. For example, the stressor layers 134 may include an epitaxial semiconductor layer having a higher concentration of Ge (e.g., in a range of (about) 75 to 100 atomic percent (at%) of Ge) than the source/drain regions 108, but the present disclosure is not limited thereto. Although FIG. 1B illustrates each stressor layer 134 as a single layer, in some embodiments, each stressor layer 134 may include multiple layers.

In some embodiments, each stressor layer 134 may extend into the upper surface of a respective source/drain region 108, which may allow for the stressor layers 134 to exert a greater degree of stress on the source/drain regions 108. A lower portion of each stressor layer 134 may thus be in a respective source/drain region 108.

The stressor layers 134 may be free of overlap with the channel structures 104 in the first direction D1. For example, a first distance between a lower surface of each stressor layer 134 and the upper surface S1 of the substrate 101 may be greater than a second distance between an upper surface 104U of each channel structure 104 and the upper surface S1 of the substrate 101. In other words, the stressor layers 134 may extend into the source/drain regions 108 to a depth in the third direction D3 that is above the upper surface 104U of each channel structure 104, relative to the upper surface S1 of the substrate 101. If the stressor layers 134 extend too deep into the source/drain regions 108, it may significantly reduce the volume (or area) of the source/drain regions 108, thereby negatively impacting the carrier mobility and/or compromising the integrity of the electrical connection between the source/drain regions 108 and the channel structures 104. By providing each stressor layer 134 so that it extends into the upper surface of a respective source/drain region 108 without overlapping the channel structures 104 in a horizonal direction (i.e., the first direction D1), the stressor layers 134 may exert a greater degree of stress on the source/drain regions 108 without substantially reducing the volume (or area) thereof.

Each stressor layer 134 may include a first portion in a source/drain region 108 and a second portion on the upper surface of the source/drain region 108. A first width of the first portion of each stressor layer 134 (in the first direction D1) may be less than a second width of the second portion of each stressor layer 134 (in the first direction D1). For example, each stressor layer 134 may have a 'T'-shape in a cross-sectional view, but the present disclosure is not limited thereto. In some embodiments, each stressor layer 134 may extend on (e.g., may cover and/or overlap) an entirety of the upper surface of a respective source/drain region 108. For example, each stressor layer 134 may extend across an entirety of the upper surface of a respective source/drain region 108 in the first direction D1 and/or the second direction D2, although embodiments are not limited thereto. By providing the stressor layer 134 so that a first portion of the stressor layer 134 in the source/drain region 108 is narrower than a second portion of the stressor layer 134 on the upper surface of the source/drain region 108, the stressor layer 134 may exert a greater degree of stress on the source/drain region 108 without substantially reducing the volume (or area) thereof.

Outer side surfaces of the source/drain regions 108 may be free of the stressor layers 134 thereon. By providing the stressor layer 134 so that it extends into the source/drain region 108 without extending on outer side surfaces thereof, the stressor layer 134 may exert a greater degree of stress on the source/drain region 108 without negatively impacting the electrical connection between the source/drain region 108 and the channel structure 104.

The stressor layers 134 may be spaced apart from each other (e.g., in the first direction D1) on the source/drain regions 108. For example, the stressor layers 134 may be spaced apart from each other, with at least one gate structure 102 therebetween. The stressor layers 134 may overlap the gate structures 102 in the first direction D1. The stressor layers 134 may be free of overlap with the gate structures 102 in the third direction D3. In other words, the stressor layers 134 may not extend onto upper surfaces of the gate structures 102. Upper surfaces of the stressor layers 134 may be substantially coplanar with each other. In some embodiments, the upper surfaces of the stressor layers 134 may be substantially coplanar with the upper surfaces of the gate structures 102 (e.g., with the upper surfaces of the gate capping layers 116).

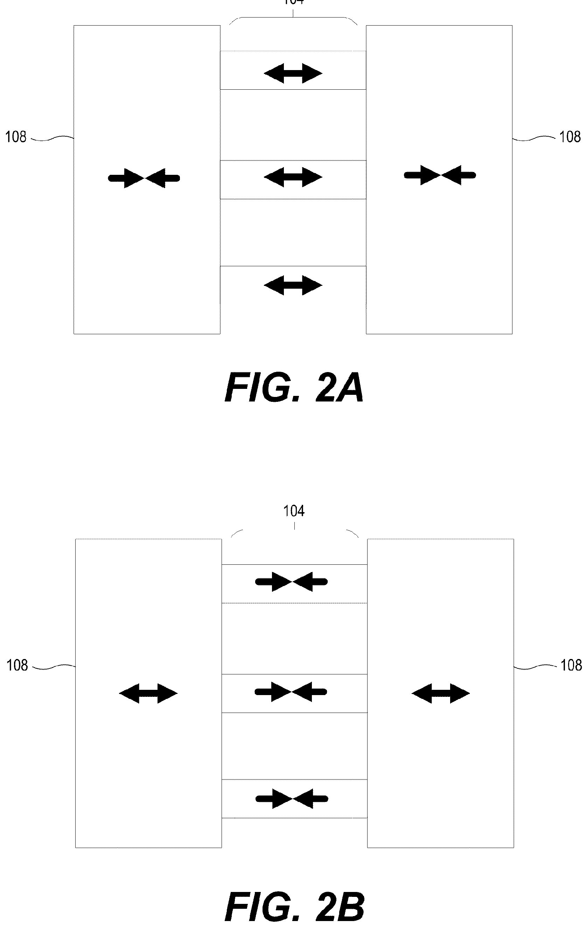

When the transistor structures TS are n-type transistors (e.g., an NMOS), the stressor layers 134 may apply compressive stress to the source/drain regions 108, and thus the stressor layers 134 may be referred to as compressive stressor layers. In other words, when the source/drain regions 108 include n-type impurities (e.g., phosphorus (P), arsenic (As), antimony (Sb), etc.), the stressor layers 134 may apply compressive stress to the source/drain regions 108. When the transistor structures TS are p-type transistors (e.g., a PMOS), the stressor layers 134 may apply tensile stress to the source/drain regions 108, and thus the stressor layers 134 may be referred to as tensile stressor layers. In other words, when the source/drain regions 108 include p-type impurities (e.g., boron (B), gallium (Ga), indium (In), etc.), the stressor layers 134 may apply tensile stress to the source/drain regions 108. As will be discussed in greater detail below with reference to FIGS. 2A and 2B, the application of stress to the source/drain regions 108 may modify the strain within the source/drain regions 108, which, in turn, may cause a desired stress to be induced in the channel structure 104, thereby enhancing the desired stress in the channel structure 104. As a result, the carrier mobility in the channel structure 104 may be improved.

The semiconductor device 100 may further include an upper gate insulating spacer 118 and a lower gate insulating spacer 120. The upper gate insulating spacer 118 may be between the gate electrode 112 and the source/drain region 108 (in the first direction D1), and may also be between the gate electrode 112 and the stressor layer 134 (in the first direction D1). For example, the upper gate insulating spacer 118 may be between an upper portion of the gate electrode 112 and an upper portion of the source/drain region 108. The upper gate insulating spacer 118 may extend on side surfaces of the gate electrode 112, the gate insulator 114, the gate capping layer 116, the source/drain region 108, and the stressor layer 134.

The lower gate insulating spacer 120 may be between the gate electrode 112 and the source/drain region 108 (in the first direction D1). For example, the lower gate insulating spacer 120 may be between a lower portion of the gate electrode 112 and a lower portion of the source/drain region 108. The lower gate insulating spacer 120 may extend on side surfaces of the gate electrode 112, the gate insulator 114, and the source/drain region 108. Portions of the lower gate insulating spacer 120 may be between adjacent ones of the channel regions 110 (in the third direction D3), and may also be between a lowermost one of the channel regions 110 and the substrate 101.

In some embodiments, the upper gate insulating spacer 118 and the lower gate insulating spacer 120 may include the same material, but the present disclosure is not limited thereto. Each of the upper gate insulating spacer 118 and the lower gate insulating spacer 120 may include, for example, silicon oxide, silicon oxynitride, silicon nitride, silicon carbonitride and/or a low-k material. In some embodiments, the upper gate insulating spacer 118 and/or the lower gate insulating spacer 120 may be omitted.

The semiconductor device 100 may further include a second interlayer 136 on an upper surface of the gate structure 102 (e.g., on an upper surface of the gate capping layer 116), an upper surface of the upper gate insulating spacer 118, and an upper surface of the stressor layer 134. For example, the second interlayer 136 may be in contact with the upper surface of the stressor layer 134. Although FIG. 1B illustrates the second interlayer 136 as a single layer, in some embodiments, the second interlayer 136 may include multiple layers. The second interlayer 136 may include, for example, silicon oxide, silicon oxynitride, silicon nitride, silicon carbonitride and/or a low-k material.

The semiconductor device 100 may further include an upper structure 138 on the second interlayer 136. The upper structure 138 may include elements formed by the middle-of-line (MOL) portion and/or the back-end-of-line (BEOL) portion of device fabrication. As used herein, the upper structure 138 may also be referred to as a BEOL structure. The upper structure 138 may include conductive elements (e.g., a wire and/or a via plug) and insulating elements (e.g., an interlayer and/or a spacer). For example, the upper structure 138 may include an interlayer insulating layer, conductive wires (e.g., metal wires) that are provided in the interlayer insulating layer and are stacked in the third direction D3, and conductive via plugs (e.g., metal via plugs), each of which may electrically connect two conductive wires that are spaced apart from each other in the third direction D3. The conductive elements of the upper structure 138 may be electrically connected to, for example, the source/drain regions 108 and/or the gate structures 102.

The gate structures 102, the channel structures 104, and the source/drain regions 108 may be provided on the upper surface S1 of the substrate 101. The semiconductor device 100 may further include backside contact structures 106 (shown by dashed lines in FIG. 1A) that are electrically connected to the source/drain regions 108. The backside contact structures 106 may extend through the substrate 101 from a lower surface (or backside) S2 of the substrate 101 to be electrically connected to the source/drain regions 108 on the upper surface (or frontside) S1 of the substrate 101. In some embodiments, lower portions of the backside contact structures 106 may be wider (in the first direction D1) than upper portions of the backside contact structures 106. Respective ones of the source/drain regions 108 may overlap respective ones of the backside contact structures 106 in the third direction D3. Respective ones of the stressor layers 134 may also overlap respective ones of the backside contact structures 106 in the third direction D3.

The backside contact structures 106 (which may also be referred to herein as backside source/drain contacts) may respectively be on lower portions (e.g., bottom portions) or lower surfaces (e.g., bottom surfaces) of the source/drain regions 108. In some embodiments, a conductive layer 124 may be provided between each backside contact structure 106 and a respective source/drain region 108. The conductive layer 124 may be provided in the first interlayer 122. For example, lower and upper surfaces of the conductive layer 124 may be substantially coplanar with lower and upper surfaces of the first interlayer 122, respectively. In some embodiments, the conductive layer 124 may include a metal silicide layer (e.g., tungsten silicide, aluminum silicide, and/or copper silicide), a metal nitride layer (e.g., titanium nitride, tantalum nitride, and/or tungsten nitride), or a combination thereof. The conductive layers 124 may contact lower surfaces of the source/drain regions 108 and upper surfaces of the backside contact structures 106, respectively. Each backside contact structure 106 may be electrically connected to a source/drain region 108 through a conductive layer 124. In some embodiments, the conductive layers 124 may be omitted, and the backside contact structures 106 may be in contact with the lower surfaces of the source/drain regions 108.

In some embodiments, as shown in FIG. 1A, a backside gate contact structure 126 (shown by dashed lines) may be provided on a lower surface of the gate structure 102 and may be electrically connected to the gate structure 102 (e.g., to the gate electrode 112). The backside gate contact structure 126 may provide a control signal (e.g., a gate voltage) to the gate structure 102. The backside contact structure 106 and/or the backside gate contact structure 126 may include a metal layer or material including, for example, W, Al, Cu, Mo, Co and/or Ru.

In some embodiments, as shown in FIG. 1A, the semiconductor device 100 may further include a frontside contact structure 128 and a frontside gate contact structure 130. At least one of the source/drain regions 108 may be electrically connected to the frontside contact structure 128 and may not overlap the backside contact structures 106 in the third direction D3. The frontside contact structure 128 may be provided in the second interlayer 136. The frontside contact structure 128 may be on an upper surface of a source/drain region 108 and may extend in the third direction D3 through the second interlayer 136. The frontside contact structure 128 may electrically connect the source/drain region 108 to a conductive element (e.g., a conductive wire and/or a conductive via plug) of the upper structure 138. In some embodiments, the frontside contact structure 128 may be omitted, and all of the source/drain regions 108 may be electrically connected to backside contact structures 106.

At least one of the gate structures 102 (e.g., at least one of the gate electrodes 112) may be electrically connected to the frontside gate contact structure 130 and may not overlap the backside gate contact structures 126 in the third direction D3. The frontside gate contact structure 130 may be provided in the second interlayer 136. The frontside gate contact structure 130 may be on an upper surface of a gate structure 102 and may extend in the third direction D3 through the second interlayer 136. The frontside gate contact structure 130 may electrically connect the gate structure 102 (e.g., the gate electrode 112) to a conductive element (e.g., a conductive wire and/or a conductive via plug) of the upper structure 138. In some embodiments, the frontside gate contact structure 130 may be omitted, and all of the gate structures 102 may be electrically connected to backside gate contact structures 126. The frontside contact structure 128 and/or the frontside gate contact structure 130 may include a metal layer or material including, for example, W, Al, Cu, Mo, Co and/or Ru.

The semiconductor device 100 may further include a backside power distribution network (BSPDN) structure 140 on the lower surface (or backside) S2 of the substrate 101. The backside contact structures 106 may electrically connect the BSPDN structure 140 to the source/drain regions 108. The BSPDN structure 140 may be provided on lower surfaces of the backside contact structures 106 and the lower surface S2 of the substrate 101. The BSPDN structure 140 may include a backside insulator 142 and one or more backside power rails 144 provided in the backside insulator 142. The backside power rail 144 may be electrically connected to the backside contact structure 106. The backside power rail 144 may include a metal layer or material including, for example, W, Al, Cu, Mo, Co and/or Ru, and the backside insulator 142 may include, for example, silicon oxide, silicon oxynitride, silicon nitride, silicon carbonitride and/or a low-k material, although embodiments are not limited thereto.

The backside power rail 144 may be electrically connected to a power source with a predetermined voltage (e.g., a drain voltage (VDD) or a source voltage (VSS)). For example, the BSPDN structure 140 may include a power delivery network. The power delivery network may include a wiring network, which is used to deliver power (e.g., gate voltages and/or source/drain voltages) to the backside power rail 144. The source/drain region 108 may be electrically connected to the power source through the backside contact structure 106 and the backside power rail 144. The backside contact structure 106 may be between the backside power rail 144 and the source/drain region 108 in the third direction D3. In some embodiments, one or more conductive plugs may be provided between the backside contact structure 106 and the backside power rail 144. The backside contact structure 106 and the conductive plug may include the same materials. For example, the backside contact structure 106 and the conductive plug may be integrated in a monolithic or unitary structure, that is, a structure formed by the same process or the same series of processes without a structurally or visibly separate interface therebetween.

As used herein, the backside power rail 144 may refer to one or more conductive elements included in the BSPDN structure 140. For example, the backside power rail 144 may include a power rail, a conductive via plug, and/or a conductive wire included in the BSPDN structure 140. That is, while illustrated as including the backside power rail 144 and the backside insulator 142, it will be understood that the BSPDN structure 140 may include one or more conductive layers (e.g., metal layers) stacked in the third direction D3 that provide backside power delivery to the transistor structures TS. The conductive layers may respectively be included in insulating layers, and conductive via plugs (e.g., metal via plugs) may electrically connect the conductive layers to each other in the third direction D3. For example, although the backside insulator 142 is illustrated as a single layer, in some embodiments, the backside insulator 142 may include multiple layers stacked on the lower surface S2 of the substrate 101. The conductive layers may include one or more conductive wires (e.g., metal wires). In some embodiments, an intervening structure may be provided between the substrate 101 and the BSPDN structure 140 and may separate the substrate 101 from the BSPDN structure 140. The BSPDN structure 140 may increase a power delivery efficiency in the semiconductor device 100, reduce an area used for power delivery in the semiconductor device 100, and/or improve a voltage drop (i.e., IR drop) in the semiconductor device 100.

FIG. 1C is a cross-sectional view taken along line A-A' of FIG. 1A according to some embodiments. As shown in FIG. 1C, a stressor layer 134' may extend on upper surfaces of the source/drain regions 108 and upper surfaces of the gate structures 102. That is, the stressor layer 134' may extend continuously on the gate structure 102, the channel structure 104, and the pair of source/drain regions 108 included in a respective transistor structure TS. For example, the stressor layer 134' may extend continuously from an upper surface of a first one of the pair of source/drain regions 108 to an upper surface of a second one of the pair of source/drain regions 108. The stressor layer 134' may extend into upper surfaces of the pair of source/drain regions 108. The stressor layer 134' may overlap the gate structure 102 and the channel structure 104 in the third direction D3. For example, the stressor layer 134' may be in contact with an upper surface of the gate structure 102 (e.g., an upper surface of the gate capping layer 116) and an upper surface of the upper gate insulating spacer 118. At least a portion of the stressor layer 134' may be between (in the third direction D3) the gate structure 102 and the second interlayer 136. Although FIG. 1C illustrates the stressor layer 134' as a single layer, in some embodiments, the stressor layer 134' may include multiple layers. The embodiment of FIG. 1C is otherwise similar to that of FIG. 1B, and thus repeated description of similar elements may be omitted for brevity.

Pursuant to example embodiments, the semiconductor device 100 may include a stressor layer 134 (134') on an upper surface of a source/drain region 108 and in contact with the source/drain region 108. The stressor layer 134 (134') may apply compressive stress or tensile stress to the source/drain region 108 to modify the strain within the source/drain region 108, which, in turn, may cause a desired stress to be induced in the channel structure 104. As a result, the carrier mobility in the channel structure 104 may be enhanced, and thus the performance and reliability of the semiconductor device 100 may be improved. In some embodiments, the stressor layer 134 (134') may extend into the upper surface of the source/drain region 108, which may allow for the stressor layer 134 (134') to exert a greater degree of stress on the source/drain region 108 without substantially reducing the volume (or area) thereof.

FIGS. 2A and 2B are simplified schematic views illustrating source/drain regions and a channel structure of a semiconductor device according to some embodiments. In particular, FIGS. 2A and 2B schematically illustrate the effects of the stressor layer 134 (134') on the source/drain regions 108 and the channel structure 104. The stressor layer 134 (134') is omitted in FIGS. 2A and 2B to help illustrate example embodiments.

Referring to FIGS. 1B, 1C, 2A, and 2B, the stressor layer 134 (134') may apply compressive stress or tensile stress to the source/drain region 108. As shown in FIG. 2A, when the stressor layer 134 (134') is a compressive stressor layer, compressive stress (shown by inward arrows) is applied to the source/drain regions 108. The compressive stress applied to the source/drain regions 108 may compress the lattice structure of the source/drain regions 108 and may thus modify the strain within the source/drain regions 108. The strain (i.e., the internal pressures) within the source/drain regions 108 caused by compression of the lattice structure thereof may, in turn, introduce tensile stress (shown by outward arrows) to the channel structure 104. That is, the stressor layer 134 (134') may apply compressive stress to the source/drain regions 108, which, in turn, may lead to the source/drain regions 108 inducing tensile stress in the channel structure 104. The tensile stress induced in the channel structure 104 may enhance the carrier mobility (e.g., the electron mobility) therein. For example, when the source/drain regions 108 include n-type impurities, the stressor layer 134 (134') may be designed to apply compressive stress to the source/drain regions 108, which, in turn, may induce tensile stress in the channel structure 104.

As shown in FIG. 2B, when the stressor layer 134 (134') is a tensile stressor layer, tensile stress (shown by outward arrows) is applied to the source/drain regions 108. The tensile stress applied to the source/drain regions 108 may stretch (or expand) the lattice structure of the source/drain regions 108 and may thus modify the strain within the source/drain regions 108. The strain (i.e., the internal pressures) within the source/drain regions 108 caused by expansion of the lattice structure thereof may, in turn, introduce compressive stress (shown by inward arrows) to the channel structure 104. That is, the stressor layer 134 (134') may apply tensile stress to the source/drain regions 108, which, in turn, may lead to the source/drain regions 108 inducing compressive stress in the channel structure 104. The compressive stress induced in the channel structure 104 may enhance the carrier mobility (e.g., the hole mobility) therein. For example, when the source/drain regions 108 include p-type impurities, the stressor layer 134 (134') may be designed to apply tensile stress to the source/drain regions 108, which, in turn, may induce compressive stress in the channel structure 104.

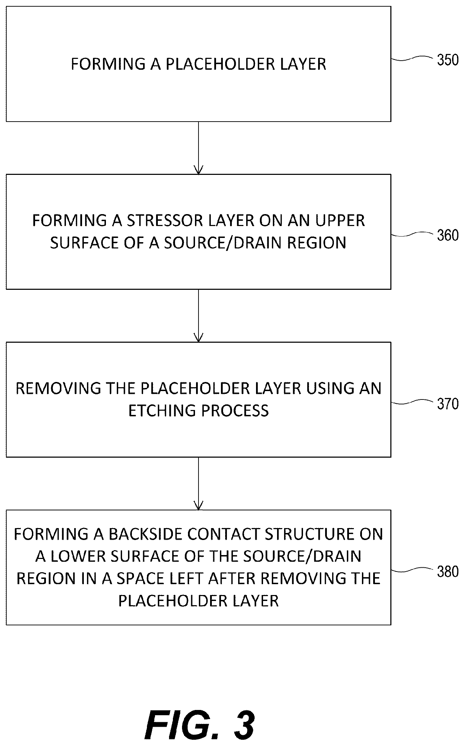

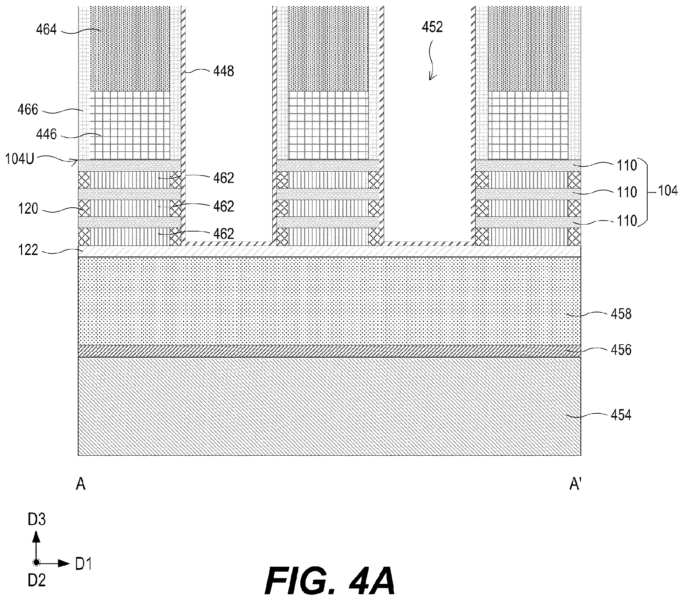

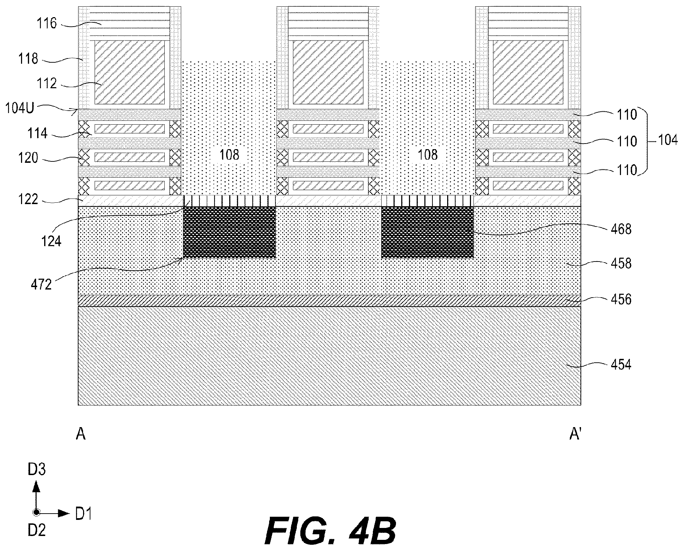

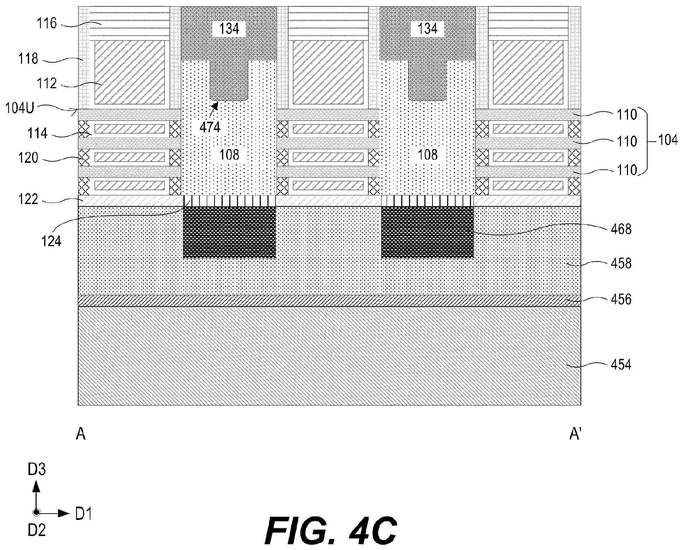

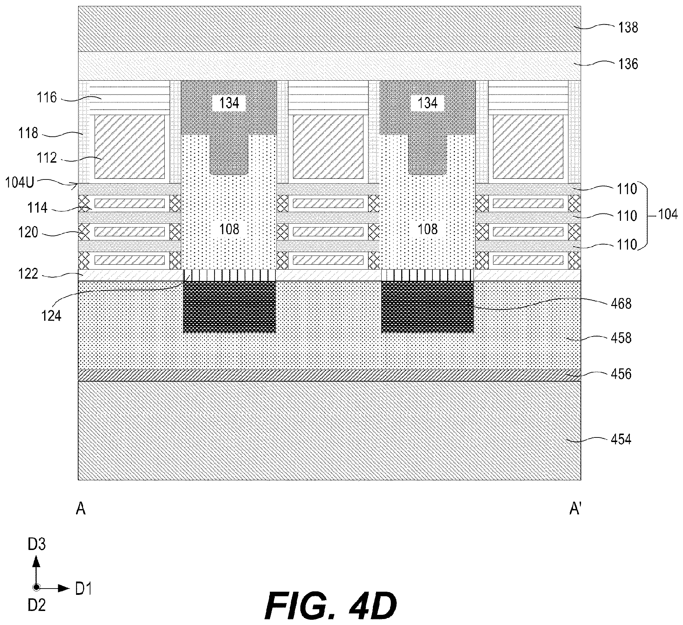

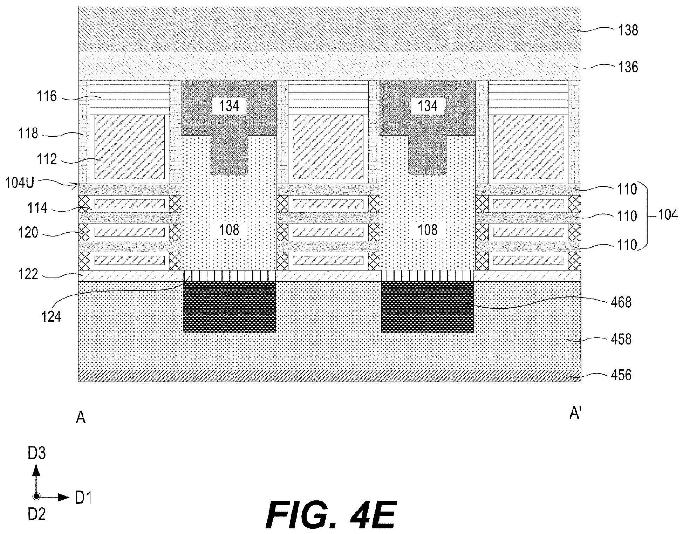

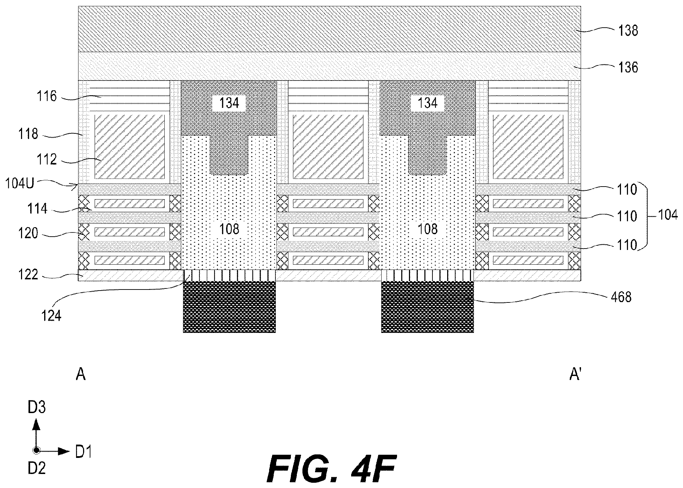

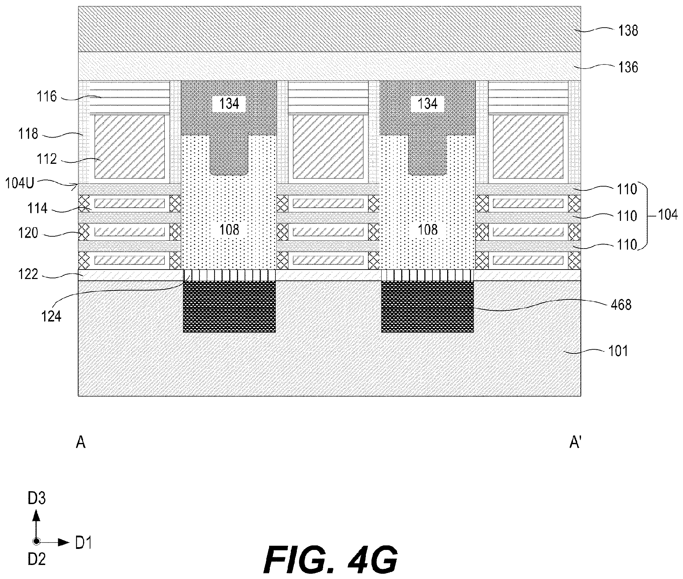

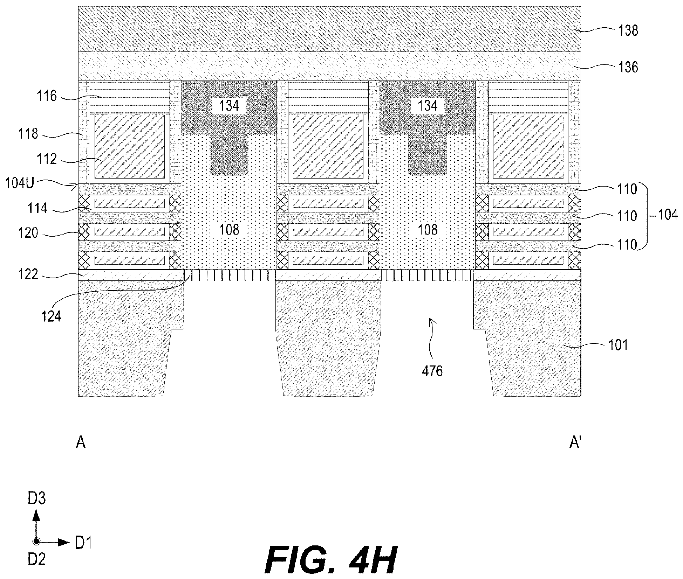

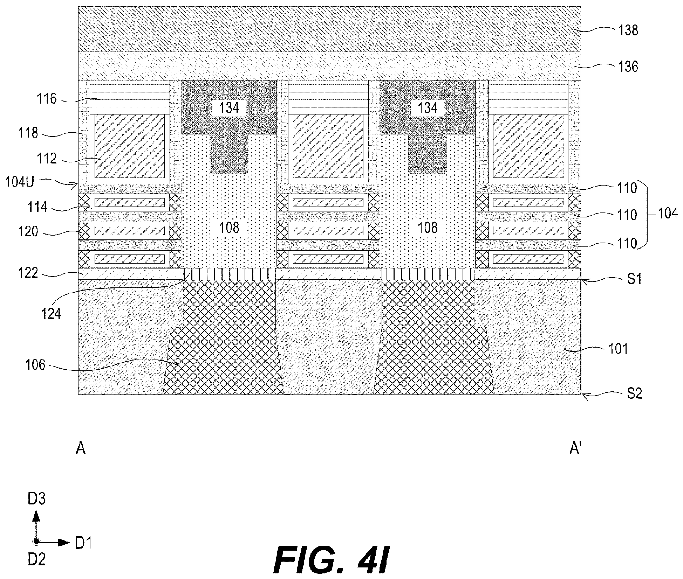

FIG. 3 is a flowchart illustrating a method of forming a semiconductor device according to some embodiments. FIGS. 4A, 4B, 4C, 4D, 4E, 4F, 4G, 4H, and 4I are cross-sectional views illustrating a method of forming a semiconductor device according to some embodiments. In particular, FIGS. 4A, 4B, 4C, 4D, 4E, 4F, 4G, 4H, and 4I are cross-sectional views corresponding to line A-A' of FIG. 1A.

As shown in FIG. 4A, an etch stop layer 456 and an epitaxial layer 458 may be formed on a preliminary substrate 454. The preliminary substrate 454, the etch stop layer 456, and the epitaxial layer 458 may be sequentially stacked in the third direction D3. A first interlayer 122 may be provided on the epitaxial layer 458.

The preliminary substrate 454 may include semiconductor material(s) (e.g., Si, Ge, SiGe, GaP, GaAs, SiC, SiGeC and/or InP) or may include insulating material(s) (e.g., silicon oxide, silicon oxynitride, silicon nitride, silicon carbonitride and/or a low-k material), although embodiments are not limited thereto. The etch stop layer 456 may include, for example, silicon germanium (SiGe). The epitaxial layer 458 may include one or more semiconductor materials, for example, silicon (Si). The epitaxial layer 458 may be doped with impurities (e.g., boron (B), phosphorus (P), etc.) to change a conductivity type (e.g., n-type or p-type) of the epitaxial layer 458. For example, the epitaxial layer 458 may be formed by an epitaxial growth process using the etch stop layer 456 as a seed layer. A doping concentration of the epitaxial layer 458 may be different from a doping concentration of the preliminary substrate 454.

Channel structures 104 may be provided on the preliminary substrate 454. Each of the channel structures 104 may include a plurality of channel regions 110 stacked in the third direction D3. In some embodiments, the channel regions 110 may be nanosheets or nanowires.

Sacrificial gate layers 462 may be provided on the preliminary substrate 454. The sacrificial gate layers 462 may be alternately stacked with the channel regions 110 in the third direction D3. The sacrificial gate layers 462 may include, for example, silicon germanium (SiGe). The sacrificial gate layers 462 may have an etch selectivity relative to the channel regions 110.

A dummy gate layer 446 may be formed on the channel structure 104. For example, a material of the dummy gate layer 446 may be formed (e.g., may be epitaxially grown or deposited) on the channel structure 104 and then may be etched. The dummy gate layer 446 may include insulating material(s) and/or semiconductor material(s). A hard mask 464 may be formed on an upper surface of the dummy gate layer 446. The hard mask 464 may include, for example, an insulating material (e.g., silicon oxide, silicon oxynitride, silicon nitride, silicon carbonitride and/or a low-k material). Insulating spacers 466 may be formed on opposing side surfaces of the dummy gate layer 446 and the hard mask 464. The insulating spacer 466 may include, for example, silicon oxide, silicon oxynitride, silicon nitride, silicon carbonitride and/or a low-k material.

The dummy gate layer 446, the hard mask 464 and the insulating spacers 466 may form a dummy gate structure. First trenches (i.e., openings) 452 may be provided between adjacent dummy gate structures. The first trenches 452 may extend in the third direction D3 through the channel structures 104. For example, the first trenches 452 may expose an upper surface of the first interlayer 122. Opposing sidewalls of the first trenches 452 may expose the respective insulating spacers 466 of adjacent dummy gate structures. The sidewalls of the first trenches 452 may also expose side surfaces of the channel regions 110 and the sacrificial gate layers 462. The first trenches 452 may be formed, for example, using an anisotropic etching process, such as reactive ion etching (RIE), wet etching, or the like, although embodiments are not limited thereto.

Lower gate insulating spacers 120 may be provided on opposing side surfaces of the sacrificial gate layers 462. For example, portions of the sacrificial gate layers 462 may be etched in a horizontal direction (e.g., the first direction D1) through the first trenches 452 to reduce widths of the sacrificial gate layers 462. The lower gate insulating spacers 120 may be formed in spaces left after etching the sacrificial gate layers 462.

A gate liner 448 may be formed in the first trenches 452 after forming the lower gate insulating spacers 120. The gate liner 448 may include, for example, a layer including nitrogen (e.g., SiN, SiON, SiBCN, SiOCN, SiBN and/or SiCN) and may have a thickness, for example, in a range of (about) 1 nm to 5 nm. In some embodiments, the gate liner 448 extends conformally on sidewalls and a bottom surface of each first trench 452. For example, the gate liner 448 may be formed on side surfaces of the dummy gate structures and an upper surface of the first interlayer 122.

As shown in FIG. 4B, a placeholder layer 468 may be formed (Block 350 in FIG. 3). For example, the placeholder layer 468 may be formed in the epitaxial layer 458.

In more detail, as shown in FIGS. 4A and 4B, an upper surface of the epitaxial layer 458 may be etched to form first recesses 472 in the epitaxial layer 458. In some embodiments, the first recesses 472 may be formed using a self-aligned etching process, with the hard mask 464, the insulating spacers 466, and/or the gate liner 448 used as an etching mask. For example, portions of the epitaxial layer 458 overlapped in the third direction D3 by the first trenches 452 may be etched to form the first recesses 472 in the epitaxial layer 458. Portions of the first interlayer 122 overlapped in the third direction D3 by the first trenches 452 may also be etched. Bottom surfaces of the first recesses 472 in the epitaxial layer 458 may not extend to the etch stop layer 456.

The placeholder layers 468 may respectively be formed in the first recesses 472. In some embodiments, the placeholder layers 468 may be epitaxially grown. For example, the placeholder layers 468 may be formed by performing an epitaxial growth process using the epitaxial layer 458 as a seed layer. In some other embodiments, the placeholder layers 468 may be formed by performing a deposition process on the first recesses 472 and then removing upper portions of the placeholder layers 468 (e.g., using an etching process). In some further embodiments, the first recesses 472 may not be formed, and the placeholder layers 468 may be formed by implanting impurities into the epitaxial layer 458 through the first trenches 452.

The placeholder layers 468 may include, for example, a semiconductor material and/or an insulating material (e.g., SiGe, SiN, and/or SiBCN). In some embodiments, the placeholder layers 468 may include a SiGe layer having a concentration of germanium in a range of (about) 15 at% to 25 at%. Upper surfaces of the placeholder layers 468 may be substantially coplanar with the upper surface of the epitaxial layer 458.

As shown in FIGS. 4A and 4B, the sacrificial gate layers 462 may be removed and replaced with gate electrodes 112 and gate insulators 114. The dummy gate layers 446 may also be removed and replaced with gate electrodes 112 and gate insulators 114. The gate electrodes 112 may include a different material from the sacrificial gate layers 462 and the dummy gate layers 446. In some embodiments, the gate electrodes 112 may be formed using a replacement metal gate (RMG) process.

The hard mask 464 may be removed, and the insulating spacers 466 may be vertically thinned (in the third direction D3). In some embodiments, a planarization process, such as, for example, a chemical mechanical polishing/planarization (CMP) process, grinding, or the like, may be performed to remove the hard mask 464. In some embodiments, the planarization process may reduce a thickness (in the third direction D3) of the insulating spacers 466, thereby forming the upper gate insulating spacers 118. A gate capping layer 116 may be formed on an upper surface of the gate electrode 112. In some embodiments, only an upper portion of the hard mask 464 may be removed by the planarization process and a lower portion thereof may remain, thereby forming the gate capping layer 116. In some other embodiments, the hard mask 464 may be entirely removed by the planarization process and the gate capping layer 116 may be formed thereafter (e.g., using a deposition process). The gate liner 448 may also be removed after forming the first recesses 472.

Source/drain regions 108 may be formed on the preliminary substrate 454. For example, the source/drain regions 108 may be formed in the first trenches 452, respectively. In some embodiments, the source/drain regions 108 may be epitaxially grown. For example, the source/drain regions 108 may be formed by performing an epitaxial growth process using the channel regions 110 as a seed layer. The source/drain regions 108 may be epitaxially grown from opposing side surfaces of the channel regions 110. A conductive layer 124 may be formed in the first interlayer 122. For example, each conductive layer 124 may be formed on a respective placeholder layer 468 before forming the source/drain regions 108. In some embodiments, the source/drain regions 108 and the placeholder layers 468 may each include a SiGe layer, and a germanium concentration of the source/drain regions 108 may be higher than a germanium concentration of the placeholder layers 468, but the present disclosure is not limited thereto.

In some embodiments, a gate structure (see the gate structure 102 in FIGS. 1B and 1C) including the gate electrode 112, the gate insulator 114, and the gate capping layer 116, the channel structure 104, and the source/drain regions 108 may be formed through front-end-of-line (FEOL) processes.

As shown in FIG. 4C, a stressor layer 134 may be formed on an upper surface of a source/drain region 108 (Block 360 in FIG. 3). For example, the stressor layer 134 may be in contact with the source/drain region 108.

In some embodiments, each stressor layer 134 may be epitaxially grown on a respective source/drain region 108. For example, the stressor layers 134 may be formed by performing an epitaxial growth process (e.g., a selective epitaxial growth (SEG) process) using the source/drain regions 108 as a seed layer. The source/drain regions 108 may undergo fewer processes when the stressor layers 134 are formed using an epitaxial growth process, which may help reduce variations in the strain within the source/drain regions 108. The epitaxial growth process may also allow for better control of the lattice structures of the source/drain regions 108. In some other embodiments, the stressor layers 134 may be formed by depositing the stressor layer 134 (i.e., depositing a material of the stressor layer 134) using a deposition process and then removing an upper portion thereof (e.g., using an etching process and/or planarization process), so that the stressor layers 134 are spaced apart from each other in the first direction D1 and are respectively provided on the source/drain regions 108.

In some embodiments, each stressor layer 134 may include an epitaxial layer having a higher concentration of Ge than the source/drain regions 108. For example, in some embodiments, each stressor layer 134 may have a concentration of Ge in a range of (about) 75 to 100 at%. In some other embodiments, the stressor layers 134 may include a dielectric material (e.g., SiOC, SiON, SiCN, SiN, Tonen SilaZene (TOSZ), tetraethyl orthosilicate (TEOS), atomic layer deposition (ALD) oxide, flowable chemical vapor deposition (FCVD) oxide, high density plasma (HDP) oxide, and/or plasma enhanced oxidation (PEOX) oxide), a metal material (e.g., tungsten (W) and/or molybdenum (Mo)), or a combination thereof.

In some embodiments, forming the stressor layer 134 may include forming a second recess 474 in the upper surface of each source/drain region 108, and then forming the stressor layer 134 in the second recess 474. For example, an upper portion of each source/drain region 108 may be removed to form the second recesses 474. In some embodiments, the upper portion of each source/drain region 108 may be removed using an etching process, such as, for example, a wet etching process and/or a dry etching process (e.g., plasma etching) to form the second recesses 474. The stressor layers 134 may respectively be formed in the second recesses 474 using, for example, an epitaxial growth process (e.g., an SEG process) and/or a deposition process (e.g., a chemical vapor deposition (CVD) process, a physical vapor deposition (PVD) process, an atomic layer deposition (ALD) process, etc.). By forming the stressor layers 134 in the second recesses 474, each stressor layer 134 may extend into the upper surface of a respective source/drain region 108, which may allow for the stressor layers 134 to exert a greater degree of stress on the source/drain regions 108.

As shown in FIG. 4D, a second interlayer 136 may be formed, and an upper structure 138 may be formed on the second interlayer 136. For example, an upper surface of the gate capping layer 116 and/or an upper surface of the stressor layer 134 may be substantially coplanar with a lower surface of the second interlayer 136. In some embodiments, a carrier wafer (not shown) may be provided on the upper structure 138 and may be used as a temporary support structure for performing subsequent backside processing. Although not shown, the frontside contact structure 128 and the frontside gate contact structure 130 (see FIG. 1A) may be formed in the second interlayer 136 before forming the upper structure 138.

As shown in FIGS. 4D and 4E, the preliminary substrate 454 may be removed, for example, by CMP processing or the like, to expose the etch stop layer 456. Although not shown in FIG. 4E, in some embodiments, the structure shown in FIG. 4D may be flipped upside down (i.e., may be inverted) during backside processing and may be supported on the carrier wafer (not shown) discussed above.

As shown in FIGS. 4E and 4F, the etch stop layer 456 and the epitaxial layer 458 may be removed, for example, by selective etching, without removing the placeholder layers 468. The first interlayer 122 and the placeholder layers 468 may be exposed after removing the etch stop layer 456 and the epitaxial layer 458. The placeholder layers 468 may include a different material from the epitaxial layer 458 and may thus have an etch selectivity relative to the epitaxial layer 458. In some embodiments, the placeholder layers 468 may include silicon germanium (SiGe), and the epitaxial layer 458 may include silicon (Si), but the present disclosure is not limited thereto.

As shown in FIG. 4G, the substrate 101 may be formed on the placeholder layers 468 and the first interlayer 122. The substrate 101 may be formed, for example, using a deposition process.

As shown in FIGS. 4G and 4H, the placeholder layer 468 may be removed using an etching process (Block 370 in FIG. 3). For example, the etching process may be selective to the material of the placeholder layers 468. Portions of the substrate 101 may also be removed by the etching process. After removing the placeholder layers 468, the surrounding substrate 101, which is not etched, will remain to thereby form second trenches 476 (i.e., openings) having a profile (i.e., boundary shape) that is similar to that of the placeholder layers 468. In other words, each second trench 476 may be a space left after removing the placeholder layers 468. In some embodiments, the etching process may result in a lower portion of each second trench 476 being wider (in the first direction D1) than an upper portion thereof. For example, the etching process may include a first etch to remove the placeholder layers 468 and a second etch to widen a lower portion of each second trench 476. Backside contact structures 106, which will be described in greater detail below, may have a reduced resistance and/or an improved electrical connection with a BSPDN structure 140 by forming each second trench 476 to have a shape that widens away from the source/drain regions 108.

As shown in FIGS. 4H and 4I, a backside contact structure 106 may be formed on a lower surface of the source/drain region 108 in a space left after removing the placeholder layer 468 (Block 380 in FIG. 3). In other words, the backside contact structures 106 may be formed in the second trenches 476, respectively. For example, a conductive material (e.g., a metal material) may be deposited in each second trench 476 to form the backside contact structures 106. The backside contact structures 106 may be electrically connected to the source/drain regions 108, respectively. For example, the backside contact structures 106 may be electrically connected to the source/drain regions 108 through the conductive layers 124, respectively.

Referring back to FIG. 1B, a BSPDN structure 140 may be formed on the backside contact structures 106. The backside contact structures 106 may be electrically connected to the BSPDN structure 140 and the source/drain regions 108. The backside contact structures 106 may be between the BSPDN structure 140 and the source/drain regions 108 in the third direction D3. The BSPDN structure 140 may include a backside insulator 142 and one or more backside power rails 144 provided in the backside insulator 142. Accordingly, the semiconductor device 100 may be formed.

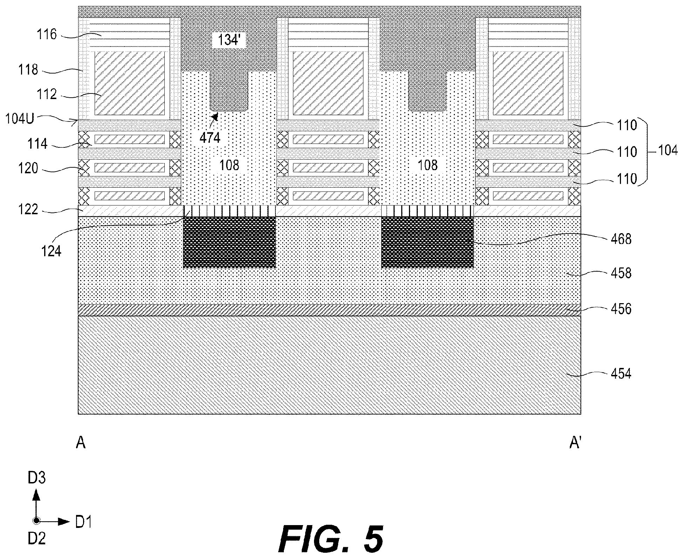

FIG. 5 is a cross-sectional view illustrating a method of forming a semiconductor device according to some embodiments. In particular, FIG. 5 is a cross-sectional view corresponding to line A-A' of FIG. 1A.

As shown in FIG. 5, after the operations described above with reference to FIGS. 4A and 4B, a stressor layer 134' may be formed on an upper surface of a source/drain region 108 (Block 360 in FIG. 3). For example, the stressor layer 134' may be in contact with the source/drain region 108.

In some embodiments, the stressor layer 134' may be formed by depositing the stressor layer 134' (i.e., depositing a material of the stressor layer 134') on the upper surfaces of the source/drain regions 108 using a deposition process (e.g., a CVD process, a PVD process, an ALD process, etc.). For example, the deposition process to form the stressor layer 134' may be more cost-effective and/or faster than an epitaxial growth process. The stressor layer 134' may be deposited on a gate structure (see the gate structure 102 in FIG. 1C) including the gate electrode 112, the gate insulator 114, and the gate capping layer 116, the channel structure 104, and the pair of source/drain regions 108 included in a respective transistor structure (see the transistor structure TS in FIG. 1C), and may thus extend continuously on the gate structure, the channel structure 104, and the pair of source/drain regions 108. In some embodiments, the stressor layer 134' may include a dielectric material (e.g., SiOC, SiON, SiCN, SiN, Tonen SilaZene (TOSZ), tetraethyl orthosilicate (TEOS), atomic layer deposition (ALD) oxide, flowable chemical vapor deposition (FCVD) oxide, high density plasma (HDP) oxide, and/or plasma enhanced oxidation (PEOX) oxide), a metal material (e.g., tungsten (W) and/or molybdenum (Mo)), or a combination thereof, but the present disclosure is not limited thereto.

In some embodiments, forming the stressor layer 134' may include forming a second recess 474 in the upper surface of each source/drain region 108, and then forming the stressor layer 134' in the second recesses 474. For example, an upper portion of each source/drain region 108 may be removed to form the second recesses 474. In some embodiments, the upper portion of each source/drain region 108 may be removed using an etching process, such as, for example, a wet etching process and/or a dry etching process (e.g., plasma etching) to form the second recesses 474. The stressor layer 134' may be formed in the second recesses 474 using, for example, a deposition process (e.g., a CVD process, a PVD process, an ALD process, etc.). By forming the stressor layer 134' in the second recesses 474, the stressor layer 134' may extend into the upper surface of each source/drain region 108, which may allow for the stressor layer 134' to exert a greater degree of stress on the source/drain regions 108.

After forming the stressor layer 134', the operations described above with reference to FIGS. 4D, 4E, 4F, 4G, 4H, 4I, and 1B may be performed. Accordingly, the semiconductor device 100 shown in FIG. 1C may be formed.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, example embodiments may be described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of the stated features, steps, operations, elements, components and/or groups, but do not preclude the presence or addition of one or more other features, steps, operations, elements, components and/or groups thereof.

It will be understood that, although the terms "first," "second," etc. may be used throughout this specification to describe various elements, these elements should not be limited by these terms. Rather, these terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terms "surround" or "cover" or "fill" as used herein may not require completely surrounding or covering or filling the described elements or layers, but may, for example, refer to partially surrounding or covering or filling the described elements or layers. Components or layers described with reference to "overlap" in a particular direction may be at least partially obstructed by one another when viewed along a line extending in the particular direction or in a plane perpendicular to the particular direction.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. The term "connected" may include physical and/or electrical connections.

Spatially relative terms such as "below" or "above" or "upper" or "lower" or "top" or "bottom" or "side" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the present disclosure should not be construed as limited to the example embodiments set forth herein. As such, it will be understood by those of ordinary skill in the art that various changes in form and details may be made therein without departing from the scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the present disclosure are also described with reference to fabrication operations and flowchart diagrams. It will be appreciated that the steps shown in the fabrication operations and flowchart diagrams need not be performed in the order shown.

## Claims

1. A semiconductor device, comprising:
a substrate (101);
a source/drain region (108) on the substrate (101);
a channel structure (104) on the substrate (101) and electrically connected to the source/drain region (108);
a gate structure (102) on the substrate (101) and at least partially surrounding the channel structure (104); and
a stressor layer (134; 134') in contact with an upper surface of the source/drain region (108) and/or extending into the upper surface of the source/drain region (108), wherein the stressor layer (134; 134') is configured to apply compressive stress or tensile stress to the source/drain region (108).

2. The semiconductor device of Claim 1, wherein a first distance between a lower surface of the stressor layer (134; 134') and an upper surface (S1) of the substrate (101) is greater than a second distance between an upper surface (104U) of the channel structure (104) and the upper surface (S1) of the substrate (101).

3. The semiconductor device of Claim 1 or 2, wherein the stressor layer (134; 134') includes a first portion in the source/drain region (108) and a second portion on the upper surface of the source/drain region (108), and
wherein a first width of the first portion of the stressor layer (134; 134') in a direction parallel to an upper surface (S1) of the substrate (101) is less than a second width of the second portion of the stressor layer (134; 134') in the direction.

4. The semiconductor device of any one of Claims 1 to 3, further comprising a backside contact structure (106) extending in the substrate (101) and electrically connected to the source/drain region (108),
wherein the stressor layer (134; 134') overlaps the backside contact structure (106) in a direction (D3) perpendicular to an upper surface (S1) of the substrate (101).

5. The semiconductor device of any one of Claims 1 to 4, wherein the stressor layer (134) is free of overlap with the gate structure (102) in a direction perpendicular to an upper surface (S1) of the substrate (101).

6. The semiconductor device of any one of Claims 1 to 5, wherein the source/drain region (108) is a first source/drain region (108),
wherein the stressor layer (134) is a first stressor layer (134), and
wherein the semiconductor device further comprises:
a second source/drain region (108) adjacent the first source/drain region (108), with the channel structure (104) therebetween; and
a second stressor layer (134) in contact with an upper surface of the second source/drain region (108) and/or extending into the upper surface of the second source/drain region (108), wherein the second stressor layer (134) is configured to apply compressive stress or tensile stress to the second source/drain region (108).

7. The semiconductor device of Claim 6, wherein the second stressor layer (134) is spaced apart from the first stressor layer (134), with the gate structure (102) therebetween.

8. The semiconductor device of any one of Claims 1 to 4, wherein the stressor layer (134') overlaps the gate structure (102) and the channel structure (104) in a direction (D3) perpendicular to an upper surface of the substrate (101).

9. The semiconductor device of any one of Claims 1 to 4 or Claim 8, wherein the source/drain region (108) is a first source/drain region (108),
wherein the semiconductor device further comprises a second source/drain region (108) adjacent the first source/drain region (108), with the channel structure (104) therebetween,
wherein the stressor layer (134') is in contact with an upper surface of the second source/drain region (108) and/or extends into the upper surface of the second source/drain region (108), and
wherein the stressor layer (134') is configured to apply compressive stress or tensile stress to the second source/drain region (108).

10. The semiconductor device of Claim 9, wherein the stressor layer (134') extends continuously from the upper surface of the first source/drain region (108) to the upper surface of the second source/drain region (108).

11. The semiconductor device of any one of Claims 1 to 10, wherein an outer side surface of the source/drain region (108) is free of the stressor layer (134; 134') thereon.

12. The semiconductor device of any one of Claims 1 to 11, wherein the stressor layer (134; 134') is configured to apply compressive stress to the source/drain region (108) when the source/drain region (108) comprises n-type impurities, and
wherein the stressor layer (134; 134') is configured to apply tensile stress to the source/drain region (108) when the source/drain region (108) comprises p-type impurities.

13. A method of forming a semiconductor device, comprising:
forming a stressor layer (134; 134') on and/or extending into an upper surface of a source/drain region (108) and in contact with the source/drain region (108),
wherein the stressor layer (134; 134') applies compressive stress or tensile stress to the source/drain region (108).

14. The method of Claim 13, wherein forming the stressor layer comprises:
forming a recess in the upper surface of the source/drain region (108); and
forming the stressor layer (134; 134') in the recess, and/or
wherein forming the stressor layer (134; 134') comprises epitaxially growing the stressor layer (134; 134') on the source/drain region (108), and/or
wherein forming the stressor layer (134; 134') comprises depositing the stressor layer (134; 134') on the upper surface of the source/drain region (108) using a deposition process.

15. The method of any Claim 13 or 14, further comprising:
forming (350) a placeholder layer (468);
removing (370) the placeholder layer (468) using an etching process; and
forming (380) a backside contact structure (106) on a lower surface of the source/drain region (108) in a space left after removing the placeholder layer (468).
